# EUROPÄISCHE PATENTANMELDUNG

(11) **EP 1 592 288 A1**
(43) Veröffentlichungstag der Anmeldung: **02.11.2005**
(21) Anmeldenummer: 05006902.0
(22) Anmeldetag: 30.03.2005
(51) Int. Cl.: H05K 1/02, H05K 7/20

(54) **Leiterplatte**

(30) Priorität: 29.04.2004 DE 202004006870 U
(71) Anmelder: Fuba Printed Circuits GmbH, 37534 Gittelde (DE)
(72) Erfinder: Freye, Jens, 37520 Osterode (DE); Novotny, Martin, 37520 Osterode (DE); Biener, Leo, 37539 Bad Grund (DE)
(74) Vertreter: Sobisch, Peter

(57) **Zusammenfassung**

Eine elektrische Leiterplatte, die aus mehreren, dielektrischen Trägerschichten (1,2,3) besteht, zwischen denen sich jeweils Leiterbilder (4,5) befinden, wobei die Außenseiten ebenfalls mit Leiterbildern (5,7) belegt sind, ist zur Verbesserung der Wärmeabfuhr mit einer durchgängigen Ausnehmung (8) versehen, deren Innenseiten mit einer Metallisierungsschicht (12) gleichförmig überzogen sind. Die Metallisierungsschicht (12) steht mit den Leiterbildern (4,5,6,7) zumindest in einem wärmeleitfähigen Kontakt und es ist in die Ausnehmung (8) im Übrigen, den Innenraum der Metallisierungsschicht (12) ausfüllend, ein aus einem metallischen Werkstoff bestehender Wärmeleitblock (9) eingesetzt, der sich gleichförmig durch die gesamte Leiterplatte hindurcherstreckt und in deren jeweiliger Ober- bzw. Unterseite endet. Der Wärmeleitblock (9) steht mit der Metallisierungsschicht (12) ebenfalls in einer wärmeleitfähigen Verbindung. Mittels Oberflächenmetallisierungsschichten (10,11), welche die zugekehrten Stirnseiten des Wärmeleitblockes (9) in den jeweiligen ober- und unterseitigen Ebenen der Wärmeplatte überragen, ist diese zusätzlich formschlüssig innerhalb der Ausnehmung (8) festgelegt. Die in den einzelnen Leiterbildern (4,5,6,7) betrieblich entwickelte Verlustwärme kann auf diesem Wege sehr effektiv abgeführt und über die äußeren Oberflächen der Metallisierungsschichten (10,11) entweder an die Umgebung oder eine mit diesen in thermischer Berührung stehende sonstige Wärmesenke abgeführt werden. Infolge flächigen Erstreckung des Wärmeleitblockes in der Grundebene der Leiterplatte ist dieser problemlos in den üblichen Fertigungsprozess der Leiterplatte intergrierbar.

## Beschreibung

Die Erfindung bezieht sich auf eine Leiterplatte entsprechend dem Oberbegriff des Anspruchs 1.

Einer zunehmenden Bestückung von Leiterplatten mit Leistungsbauelementen sind bekanntlich in thermischer Hinsicht Grenzen gesetzt, da besondere Maßnahmen zur Ableitung einer hiermit einhergehenden hohen Verlustwärme verbunden sind. Diese Maßnahmen bestehen regelmäßig in der Anordnung von Wärmesenken in der Form von aus Kupfer oder Aluminium bestehenden, zur Wärmeableitung bemessenen und angeordneten Kühlplatten.

So ist aus dem EP 0 934 687 B1 eine Leiterplatte bekannt, bei welcher ein Trägersubstrat beidseitig Leiterbilder trägt, wobei eine Seite zusätzlich mit Leistungsbauelementen bestückt ist und wobei die dieser gegenüberliegende Seite über eine Zwischenschicht aus einem wärmeleitfähigen Füllstoff mit einem metallischen Kühlkörper in Verbindung steht. Zwischen den Leitbildern erstrecken sich Durchkontaktierungen, so dass die über die Leiterbilder sowie die Leistungsbauelemente entwickelte Verlustwärme durch freie Konvektion über die Außenseite des plattenförmigen Kühlkörpers abgeleitet werden muss.

Aus der DE 195 32 992 A1 ist eine weitere, mit einem plattenförmigen Kühlkörper versehene Leiterplatte bekannt, auf der oder in der sich Leiterbahnen befinden, die einseitig mit elektrischen Bauteilen bestückt ist und deren eine Seite über eine Klebefolie mit einem aus Aluminium bestehenden Kühlkörper in Verbindung steht. In eine, sämtliche dieser Schichten durchdringende Ausnehmung ist zur Bildung einer Wärmeleitbrücke ein Kupferbolzen eingepresst, der auf der Seite des Kühlkörpers zur Bildung einer axial formschlüssig wirkenden Sicherung mit einem Ringflansch versehen ist und der auf seiner, dem Kühlkörper abgekehrten Seite mit einem Leistungsbauelement in unmittelbarem thermischen Kontakt steht.

Diese bekannten Wärmeabfuhrtechniken führen jedoch nicht in allen Fällen zu zufriedenstellenden Ergebnissen. Auch führt die Notwendigkeit einer Kühlplatte zu einem erhöhten Aufwand bei der Herstellung derartiger Leiterplatten.

Es ist daher die Aufgabe der Erfindung, eine Leiterplatte der eingangs bezeichneten Art bei einfacher Herstellungsmöglichkeit mit Hinblick auf eine verbesserte Wärmeabfuhr hin auszugestalten. Gelöst ist diese Aufgabe bei einer solchen Leiterplatte durch die Merkmale des Kennzeichnungsteils des Anspruchs 1.

Erfindungswesentlich ist hiernach ein Wärmeleitblock, der von seiner stofflichen Beschaffenheit her zu einer effizienten Wärmeleitung geeignet ist. Dieser Wärmeleitblock steht zumindest mit dem sich auf einer Oberfläche der Leiterplatte erstreckenden Leiterbild in einem wärmeleitfähigen Kontakt, so dass die durch die Leiterbahnen des Leiterbildes betrieblich entwickelte Verlustwärme über dem Wärmeleitblock abführbar ist. Dieser Wärmeleitblock weist in den genannten Stirnseiten eine solche flächige Erstreckung auf, dass zusätzliche, aus dem Stand der Technik heraus bekannte Wärmeableitbleche bzw. Kühlplatten nicht erforderlich sind. Der Wärmeleitblock wird dementsprechend eine flächige, sich in der Grundebene der Leiterplatte erstreckende Gestalt aufweisen und ist bereits auf diesem Grunde zur problemlosen Integration in den Fertigungsprozess der Leiterplatte geeignet. Nachdem sich der Wärmeleitblock über die gesamte Dicke der Leiterplatte erstreckt, ist dieser nicht nur zur Ableitung der in den Leiterbahnen entwickelten Verlustwärme sondern gleichermaßen auch zur Ableitung von Wärme der Trägerschicht geeignet.

Der Wärmeleitblock kann stofflich in unterschiedlicher Weise hergestellt werden. Es kann sich beispielsweise um einen im Ausgangszustand pastösen Werkstoff handeln, der in eine vorbereitete Ausnehmung der Trägerschicht eingebracht wird und in dieser aushärtet. Im einfachsten Fall handelt es sich um einen ausschließlich wärmeleitfähigen, elektrisch jedoch isolierend wirkenden Stoff. Entsprechend den Merkmalen des Anspruchs 2 besteht jedoch der Wärmeleitblock aus einem metallischen Werkstoff, somit einem außerhalb der Ausnehmung der Leiterplatte vorgefertigten, an diese angepassten metallischen Körper, der z.B. aus Kupfer oder Aluminium besteht und innerhalb der Ausnehmung festgelegt ist. Dies kann beispielsweise durch Einpressen, Einkleben oder in sonstiger Weise auch formschlüssig geschehen.

Entsprechend den Merkmalen des Anspruchs 3 steht der Wärmeleitblock in einem elektrisch leitfähigen Kontakt mit dem Leiterbild. Er ist auf diese Weise auch in die elektrische Schaltung beispielsweise in der Form eines niederohmigen Leiters eingebunden.

Gemäß den Merkmalen des Anspruchs 4 ist wenigstens eine Stirnseite des Wärmeleitblockes mit einer Oberflächenmetallisierungsschicht überzogen, die sich über die Berandung der Ausnehmung hinauserstreckt. Neben einer auf diese Weise gegebenen zusätzlichen mechanischen Fixierung des Wärmeleitblockes ist dessen eine Stirnseite somit zur unmittelbaren Anbindung von Leistungs-Bauelementen (SMD, Surface Mounted Device) vorbereitet. Diese Verlustwärme erzeugende Bauelemente stehen über die Metallisierungsschicht in einem unmittelbaren thermischen Kontakt mit dem Wärmeleitblock, so dass eine besonders effektive Kühlwirkung gegeben ist. Für eine Anbindung von SMD-Bauelementen stehen grundsätzlich beide Stirnseiten des Wärmeleitblockes zur Verfügung.

Gemäß den Merkmalen des Anspruchs 5 sind die Innenwandungen der Ausnehmung gleichförmig mit einer Metallisierungsschicht überzogen, wobei der Wärmeleitblock mit dieser Metallisierungsschicht in einem zumindest wärmeleitfähigen Kontakt steht. Diese Metallisierungsschicht erfüllt somit die Funktion einer Durchkontaktierung, die sich von der Oberseite der Leiterplatte bis zu deren Unterseite erstreckt. Sie bildet somit einen Teil der elektrischen Schaltung, wobei deren Verlustwärme insbesondere aufgrund des großflächigen Kontaktes mit dem Wärmeleitblock besonders effektiv abgeleitet werden kann.

Die Merkmale der Ansprüche 6 und 7 sind auf eine weitere Ausgestaltung dieser Funktionsprinzipien gerichtet. Die Metallisierungsschicht kann hiernach auch in einem unmittelbaren elektrischen Kontakt mit dem Wärmeleitblock stehen, so dass über den Wärmeleitblock sämtliche Leiterbilder der Leiterplatte in thermischer Verbindung stehen. Leiterbilder können hiernach ober- und unterseitig vorgesehen sein, wobei gleiches für SMD-Bauelemente gilt.

Die besonderen Vorteile einer erfindungsgemäßen ausgestalteten Leiterplatte kommen jedoch erst im Falle der Merkmalskombination des Anspruchs 8 zum Ausdruck, nämlich bei Mehrebenen-Leiterplatten oder Multylayer-Platten. Derartige Leiterplatten zeichnen sich häufig durch eine besonders hohe Komponenten- und Leiterbahndichte auf, so dass dementsprechend das Problem einer effektiven Wärmeabfuhr entsteht. Zwar stehen die Leiterbahnen der einzelnen Leiterebenen untereinander über zahlreiche Durchkontaktierungen in elektrischer und damit auch wärmeleitfähiger Verbindung - dieser Umstand ist jedoch an sich für eine effektive Wärmeableitung völlig unzureichend. Dadurch, dass sich der erfindungsgemäße Wärmeleitblock von der Unterseite bis zur Oberseite einer Multilayer-Platte erstreckt, wobei sämtliche Leiterbilder entweder unmittelbar oder über eine Metallisierungsschicht der Innenwandungen der Ausnehmung mit dem Wärmeleitblock in einem thermischen Kontakt stehen, ist eine besonders effiziente Wärmeableitung auch aus dem Inneren der Leiterplattenstruktur gegeben. Auch lässt sich die Verwendung derartiger Wärmeleitblöcke problemlos in eine vorhandene Fertigung von Mehrebenen-Leiterplatten integrieren.

Entsprechend der flächigen Erstreckung der Leiterplatte, jedoch auch der flächenhaften Verteilung besonderer, Verlustwärme erzeugender Leistungs-Bauelemente können entsprechend den Merkmalen des Anspruchs 9 mehrere flächige Wärmeleitblöcke in der Ebene der Leiterplatte voneinander beabstandet angeordnet sein. Deren sich innerhalb der Ebenen der Oberseite oder der Unterseite erstreckende freie Stirnflächen können in unmittelbarem thermischen oder auch elektrischen Kontakt mit einem Wärmeleitblock stehen.

Entsprechend den Merkmalen des Anspruchs 10 kann wenigstens eine freie Stirnseite des Wärmeleitblockes in unmittelbarem thermischen Kontakt mit einer Wärmesenke stehen. Diese Wärmesenke kann durch die Umgebungsluft gebildet sein - es kann jedoch auch ein unmittelbarer Kontakt zu einem sonstigen Kühlmedium bestehen. Besonders vorteilhaft kann die freie Stirnseite auch in unmittelbarem thermischen Kontakt mit der metallischen oder in sonstiger Weise wärmeleitfähigen Wandung eines Gerätegehäuses stehen bzw. selbst unmittelbar ein integraler Bestandteil einer Gehäusewandung sein.

Alternativ hierzu können entsprechend den Merkmalen des Anspruchs 11 gegebenenfalls ein Teil der mehreren Wärmeleitblöcke einer Leiterplatte oberund/unterseitig unmittelbar mit Leistungs-Bauelementen im Wärmeaustausch stehen bzw. im Fall einer elektrischen Anbindung entweder an die genannten Bauelemente und/oder zumindest einen Teil der Leiterbahnen in den elektrischen Schaltkreis integriert sein.

Die Anwendung der Erfindung ist nicht auf ebene Leiterplatten beschränkt - sie kann gleichermaßen auch Anwendung finden bei räumlich gekrümmten, insbesondere dreidimensionalen Leiterplatten. Insgesamt wird eine zu einer besonders effektiven Wärmeableitung eingerichtete, eine hohe Bauteildichte ermöglichende Leiterplatte zur Verfügung gestellt, bei der elektrische Funktionen und Wärmeleitfunktionen nahezu beliebig kombinierbar sind.

Die Erfindung wird im Folgenden unter Bezugnahme auf die in den Zeichnungen schematisch wiedergegebenen Ausführungsbeispiele näher erläutert werden. Es zeigen:
Fig. 1 eine Darstellung einer ersten Ausführungsform einer erfindungsgemäßen Leiterplatte in einem Querschnitt;
Fig. 2 eine Darstellung einer zweiten erfindungsgemäßen Leiterplatte in einem Querschnitt.

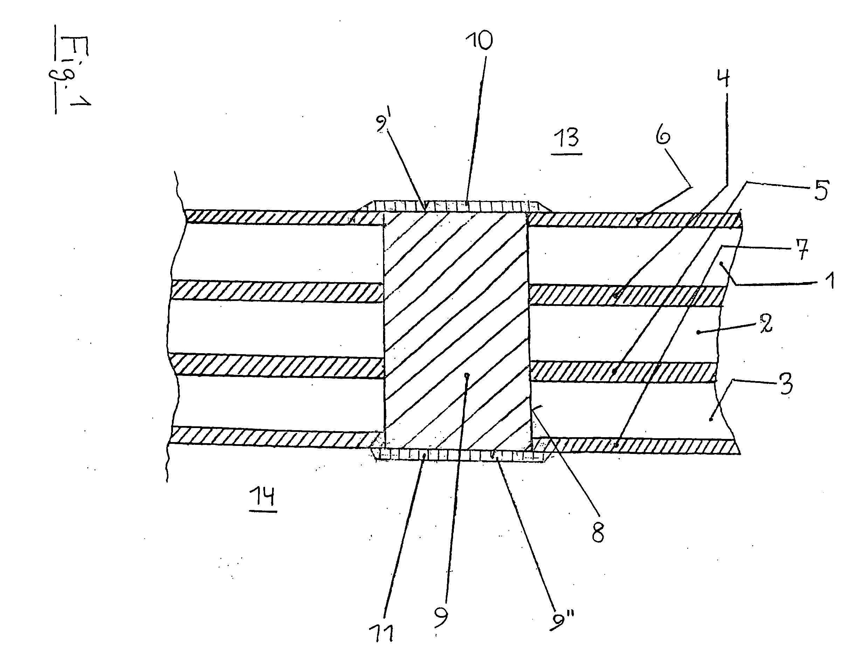

Die in Fig. 1 dargestellte Leiterplatte ist aus mehreren Ebenen zusammengesetzt und besteht aus drei dielektrischen Schichten 1, 2, 3 zwischen denen sich jeweils elektrische Leiterbilder 4, 5 befinden, wobei weitere elektrische Leiterbilder 6, 7 mit der Unterseite bzw. der Oberseite der Leiterplatte in üblicher Weise verbunden sind.

Die Leiterbilder dieser einzelnen Ebenen stehen in üblicher, hier nicht näher dargestellter Weise über Durchkontaktierungen in elektrischer Verbindung und bilden eine einheitliche Schaltung, in welche elektrische Leistungsbauelemente, z.B. Halbleiter-Baugruppen eingebunden sind, die außenseitig in üblicher Weise mit dem Leiterbild 6, 7 verschaltet sind. Mit 8 ist eine, sämtliche Schichten 1 bis 3 sowie Leiterbilder 4 bis 7 durchdringende Ausnehmung bezeichnet, in welche ein aus Kupfer bestehender Wärmeleitblock 9 eingesetzt und in geeigneter Weise fixiert ist. Dies kann beispielsweise durch Einpressen geschehen. Wesentlich ist, dass der Wärmeleitblock 9 zumindest in thermischem Kontakt mit den Leiterbildern 4 bis 7 steht. Er kann hierüber hinaus zusätzlich auch als niederohmiger Leiter mit diesen Leiterbildern in elektrischem Kontakt stehen. Ein lediglich thermischer Kontakt mit den Leiterbildern 4 bis 7 kann beispielsweise unter Zwischenanordnung einer zeichnerisch nicht dargestellten, elektrisch isolierend wirkenden jedoch wärmeleitfähigen Schicht eingerichtet sein.

Mit 10, 11 sind Oberflächenmetallisierungsschichten bezeichnet, welche die Berandung der Ausnehmung 8 überragen. Von diesen beiden Schichten gehen unterschiedliche Wirkungen aus. Diese dienen zum einen der mechanischen Befestigung des Wärmeleitblockes 9 innerhalb der Ausnehmung 8. Sie können jedoch auch dazu benutzt werden, direkt mit einem Leistungsbauelement verlötet zu werden und somit in einen elektrischen Schaltkreis eingebunden zu werden. Dies bedeutet, dass der Wärmeleitblock 9 ein definiertes elektrisches, durch die Schaltung vorgegebenes Potential annimmt. Sie können jedoch auch lediglich in einem thermischen Kontakt mit Leistungsbauelementen stehen.

Von wesentlicher Bedeutung ist auch, dass durch die Oberflächenmetallisierungschichten 10, 11, welche die angrenzenden Leiterbahnen 6, 7 überragen, eine besonders wirksame Wärmeableitung von den Leiterbahnen 6, 7 auf den Wärmeleitblock 9 gegeben ist.

Eine wärmeleitfähige Verbindung besteht gleichermaßen zwischen den Leiterbahnen 4, 5 und dem Wärmeleitblock 9. Dies ist von besonderer Bedeutung, da die bei derartigen Mehrebenen-Leiterplatten in diesen Leiterbahnen entwickelte Verlustwärme ansonsten kaum ableitbar ist. Zwischen diesen inneren Leiterbahnen 4, 5 und dem Wärmeleitblock 9 kann eine thermisch und elektrisch wirksame Verbindung eingerichtet sein - in diesem Fall kommt dem Wärmeleitblock 9 die Funktion eines niederohmigen Leiters zu. Gleichermaßen kann jedoch zwischen den Leiterbahnen 4, 5 und dem Wärmeleitblock 9 eine ausschließlich wärmeleitfähige, elektrisch jedoch isolierende Verbindung bestehen, welches durch Zwischenfügung einer an sich bekannten, wärmeleitfähigen, jedoch elektrisch isolierenden Masse möglich ist.

Der Wärmeleitkörper 9 kann seinerseits in zeichnerisch nicht dargestellter Weise mit einem metallischen Gehäuse oder einer weiteren Wärmesenke in Verbindung stehen, über welche eine Kühlung durch natürliche Konvektion oder auch ein externes Kühlmittel gegeben ist.

In jedem Fall eröffnet der erfindungsgemäße Aufbau einer Mehrebenen-Leiterplatte eine besonders effektive Wärmeabfuhr auch aus deren inneren Leiterbahnebenen heraus.

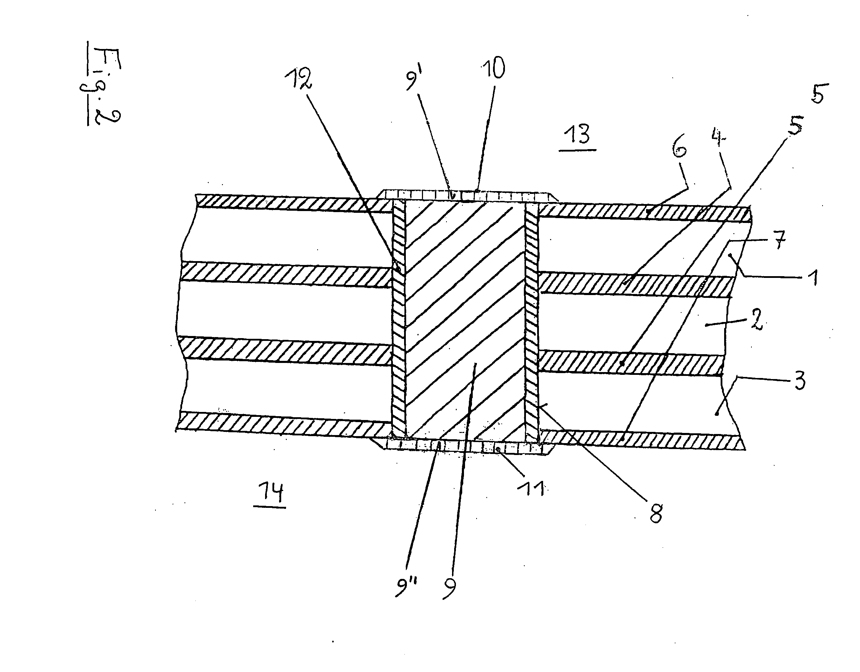

In dem Ausführungsbeispiel gemäß Fig. 2 sind Funktionselemente, die denjenigen gemäß Fig. 1 entsprechen, in gleicher Weise beziffert, so dass auf eine diesbezügliche wiederholte Beschreibung verzichtet werden kann.

Dieses Ausführungsbeispiel unterscheidet sich von demjenigen gemäß Fig. 1 jedoch darin, dass die Innenseite der Ausnehmung 8 mit einer durchgängigen Metallisierungsschicht 12 überzogen ist, die mit sämtlichen Leiterbahnen 4 bis 7 in einer zumindest thermisch leitfähigen Verbindung steht. Diese Metallisierungsschicht 12 bildet einen mit den Wandungen der Ausnehmung 8 in fester Verbindung stehenden, eine im Wesentlichen gleichförmige Dicke aufweisenden Hohlkörper, in welchen der Wärmeleitblock 9 eingefügt ist. Das Einfügen ist wiederum derart angelegt, dass der Wärmeleitblock 9 allseitig in einer wärmeleitfähigen Verbindung mit der Metallisierungsschicht 12 steht, so dass die Bedingungen der Wärmeableitung insbesondere aus den inneren Leiterbahnen 4, 5 weiter verbessert werden.

Die Oberflächenmetallisierungsschichten 10, 11 können in gleicher Weise wie diejenigen gemäß Fig. 1 ausgebildet sein, d.h. sie sind mit der Maßgabe angelegt, dass deren Berandungen diejenigen der Ausnehmung 8 - in deren Umfangsrichtung gesehen - gleichförmig überragen.

Der Wärmeblock 9 weist in jedem Fall eine Querschnittsgröße auf, welche eine fühlbare Wärmeableitung bereits über die freie Oberfläche der Oberflächenmetallisierungsschichten 10, 11 ermöglicht. Wesentlich ist auch, dass sich die Stirnseiten 9', 9" des Wärmeleitblockes 9 sich in den Ebenen der Oberseite 13 sowie der Unterseite 14 erstrecken. Der Querschnitt des Wärmeleitblockes 9 kann an sich beliebig gestaltet sein und nach konkreten Randbedingungen der Schaltung bzw. der Wärmeableitung bemessen werden.

Eine in diesem Sinne eingerichtete Leiterplatte kann nach Maßgabe einer hohen Bestückungsdichte auf ihrer Oberseite 13 und gleichzeitig auf ihrer Unterseite 14 mit Leistungsbauteilen ausgerüstet sein, deren Verlustwärme über den Wärmeleitblock 9 abgeführt wird.

## Patentansprüche

1. Elektrische Leiterplatte, bestehend aus wenigstens einer dielektrischen Trägerschicht (1,2,3) und einem, zumindest auf deren einer Seite angebrachten, eine elektrische Schaltung darstellenden Leiterbild (4,5,6,7) **gekennzeichnet durch** zumindest einen flächigen, in eine durchgängige Ausnehmung (8) der Trägerschicht (1,2,3) eingesetzten Wärmeleitblock (9), der mit dem Leiterbild zumindest in einem wärmeleitfähigen Kontakt steht und dessen Stirnseiten (9',9") sich im Wesentlichen bündig zu den Ebenen der Oberseite (13) sowie der Unterseite (14) der Leiterplatte erstrecken.

2. Leiterplatte nach Anspruch 1, **dadurch gekennzeichnet, dass** der Wärmeleitblock (9) aus einem metallischen Werkstoff besteht.

3. Leiterplatte nach Anspruch 1 oder 2, **dadurch gekennzeichnet, dass** der Wärmeleitblock (9) in einem elektrisch leitfähigen Kontakt mit dem Leiterbild (4,5,6,7) steht.

4. Leiterplatte nach einem der vorangegangenen Ansprüche 1 bis 3, **dadurch gekennzeichnet, dass** zumindest eine Stirnseite (9',9") des Wärmeleitblockes (8) mit einer Oberflächenmetallisierungsschicht (10,11) überzogen ist, die sich über die Berandung der Ausnehmung (8) hinauserstreckt.

5. Leiterplatte nach einem der vorangegangenen Ansprüche 1 bis 4, **dadurch gekennzeichnet, dass** die Innenwandungen der Ausnehmung (8) gleichförmig mit einer Metallisierungsschicht (12) überzogen sind und dass der Wärmeleitblock (9) mit dieser Metallisierungsschicht zumindest in einem wärmeleitfähigen Kontakt steht.

6. Leiterplatte nach Anspruch 5, **dadurch gekennzeichnet, dass** der Wärmeleitblock (9) mit der Metallisierungsschicht (12) in einem elektrisch leitfähigen Kontakt steht.

7. Leiterplatte nach einem der vorangegangenen Ansprüche 1 bis 6, **dadurch gekennzeichnet, dass** die Oberseite (13) und die Unterseite (14) mit Leiterbildern (6,7) belegt sind.

8. Leiterplatte nach einem der vorangegangenen Ansprüche 1 bis 7, **dadurch gekennzeichnet, dass** wenigstens drei durch dielektrische Trägerschichten (1,2,3) voneinander getrennte Leiterbilder (4,5,6,7) in zueinander parallelen Ebenen vorgesehen sind.

9. Leiterplatte nach einem der vorangegangenen Ansprüche 1 bis 8, **gekennzeichnet durch** zwei oder mehrflächige, in der Ebene der Leiterplatte voneinander beabstandete Wärmeleitblöcke (9).

10. Leiterplatte nach einem der vorangegangenen Ansprüche 1 bis 9, **dadurch gekennzeichnet, dass** wenigstens eine in der Ebene der Oberseite (13) bzw. der Unterseite (14) sich erstreckende Stirnseite (9',9") des Wärmeleitblockes (9) eine freie, zur Wärmeübertragung in Richtung auf eine Wärmesenke hin bestimmte Oberfläche bildet.

11. Leiterplatte nach einem der vorangegangenen Ansprüche 1 bis 10, **dadurch gekennzeichnet, dass** zumindest eine der Stirnseiten (9',9") des Wärmeleitblockes (9) in direktem thermischen Kontakt mit einem Leistungs-Bauelement eines Leiterbildes steht.
